# FASCICULE DE BREVET EUROPEEN

(11) **EP 0 350 123 B1**
(45) Date de publication et mention de la délivrance du brevet: **20.04.1994**
(21) Numéro de dépôt: 89201755.9
(22) Date de dépôt: 03.07.1989
(51) Int. Cl.: G01R 31/26

(54) **Dispositif de caractérisation d'échantillons semiconducteurs par photoluminescence à haute résolution spatiale et à basse température**
Anordnung zum Charakterisieren von Halbleitern durch Hoch-Resolution-Elektro-Lumineszenz bei niedriger Temperatur
Appliance for characterising semiconductor samples by high-resolution electroluminescence at a low temperature

(30) Priorité: 08.07.1988 FR 8809296
(43) Date de publication de la demande: 10.01.1990
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Le Bris, Jean Société Civile S.P.I.D., F-75007 Paris (FR); Erman, Marko Société Civile S.P.I.D., F-75007 Paris (FR); Gillardin, Gérard Société Civile S.P.I.D., F-75007 Paris (FR)
(74) Mandataire: Landousy, Christian

(56) Documents cités:
- EP-A- 0 216 077
- J. APPL. PHYS., vol. 50, no. 8, August 1979, pages 5453-5460, American Institute of Physics; K. BÖHM et al.: "Photoluminescence at dislocations in GaAs and InP"
- JPN. J. APPL. PHYS., vol. 23, no. 5, 1984, page 663; M. YOKOGAWA et al.: "Computer-controlled mapping of photoluminescence intensities"
- JPN. J. APPL. PHYS., vol. 24, no. 11, 1985, pages 1565-1566; T. SHIRAKAWA et al.: "Photoluminescence measurement in GaAs with high spatial resolution"

## Description

L'invention concerne un dispositif de caractérisation de plaquettes de matériaux semiconducteurs par photoluminescence à haute résolution spatiale et à basse température, ce dispositif comprenant au moins :
a) une chambre à vide cryostatique, munie d'un porte-échantillon refroidi pour recevoir les plaquettes, et munie d'au moins une fenêtre pour la transmission des faisceaux lumineux impliqués dans le procédé de photoluminescence ;
b) des moyens optiques pour former une tache d'éclairement sur la plaquette à partir d'un faisceau laser et pour transmettre le faisceau de photoluminescence réémis à un détecteur.

L'invention trouve son application dans l'étude de la distribution des défauts natifs et des impuretés liées aux dislocations dans les cristaux semiconducteurs non dopés, ainsi que dans l'étude de l'uniformité et de la concentration des agents dopants dans les cristaux semiconducteurs dopés.

Un dispositif de caractérisation d'échantillons par photoluminescence à haute résolution spatiale est déjà connu par la publication intitulée "Photoluminescence Measurement in GaAs with high Spatial Resolution", par Tsuguru SHIRAKAWA et alii dans JPN.J.APPL. PHYS. VOL.24 (1985) n°11 pp.1565-1566.

Un autre dispositif de caractérisation d'échantillons par photoluminescence à haute résolution spatiale est aussi connu par la publication intitulée "Photoluminescence at dislocations in GaAs and InP" par K.Böhm and B. Fisher dans J.APPL.PHYS. 50(8), August 1979, 1979 American Institute of Physics pp.5453-5460.

Selon l'un ou l'autre de ces dispositifs connus, l'échantillon à caractériser est maintenu dans une petite chambre à vide cryostatique qui est pourvue d'une seule fenêtre.

Un microscope est utilisé deux fois : une première fois pour focaliser un faisceau laser sur la surface à étudier de l'échantillon refroidi placé dans la chambre cryostatique ; et une seconde fois pour transformer en un faisceau parallèle le faisceau de photoluminescence réémis par l'échantillon à une longueur d'onde différente de celle du faisceau incident.

Le microscope étant situé à l'extérieur de la chambre à vide cryostatique, à la fois le faisceau incident et le faisceau réémis sont convergents lorsqu' ils traversent la fenêtre de cette chambre cryostatique.

Le faisceau laser incident est amené dans l'axe du microscope par le moyen d'une lame semi-réfléchissante, et le faisceau réémis est amené, après traversée du microscope, dans un monochromateur, par le moyen d'une lame réfléchissante située au-delà de la lame semi-réfléchissante sur le trajet du faisceau réémis, dans l'axe du microscope.

A la sortie du monochromateur, un détecteur envoie les informations à un système de traitement de données.

Pour permettre le balayage de la plaquette échantillon par le faisceau laser incident, c'est l'ensemble du cryostat qui est placé sur une platine de déplacement X-Y. De ce fait la dimension de la fenêtre du cryostat et la dimension de la plaquette échantillon doivent être du même ordre de grandeur.

Comme d'autre part, on a vu que les faisceaux qui traversent la fenêtre du cryostat sont convergents, l'épaisseur de cette fenêtre, qui est une lame à faces parallèles, doit être aussi faible que possible, de manière à perturber le moins possible ces faisceaux convergents.

Mais cette fenêtre est soumise à d'autres conditions du fait qu'elle ferme la chambre à vide. Pour tenir le vide, l'épaisseur de cette fenêtre doit être d'autant plus grande que son diamètre est grand.

C'est pourquoi, dû au fait que le dispositif selon l'état de la technique est prévu tel que les faisceaux qui traversent la fenêtre de la chambre à vide cryostatique sont convergents, ce dispositif présente les inconvénients suivants :
- la fenêtre présente une épaisseur faible, d'où il résulte qu'elle présente un petit diamètre, ce qui entraîne que le diamètre maximal des échantillons qui peuvent être caractérisés au moyen de ce dispositif doit aussi être faible.

D'autre part, dû au fait que l'ensemble du cryostat doit être déplacé pour balayer l'échantillon par la tâche d'éclairement, et que la tâche d'éclairement par le faisceau incident est petite, la vitesse à laquelle sont effectuées les mesures est petite.

Mais à ces inconvénients s'ajoute encore un inconvénient beaucoup plus grand, lié au principe même de formation de l'image de photoluminescence.

Comme on l'a dit précédemment, le microscope est chargé de former à partir du faisceau laser à peu près parallèle, une petite tache focalisée sur la surface à étudier. Puis le microscope reprend la lumière réémise par cette petite tache. La résolution spatiale de l'appareil dépend donc du diamètre de cette tache toutes les fois que ladite tache présente une dimension supérieure à la longueur de diffusion des porteurs minoritaires dans la plaquette à étudier. Comme ce microscope est un microscope à lentilles, la tache d'éclairement ne peut être inférieure à 2 µm. Elle est alors du même ordre de grandeur que la longueur de diffusion, et par conséquent peut limiter la résolution. Donc ce dispositif ne permet pas d'atteindre la résolution maximale.

Enfin un tel microscope à lentilles ne peut couvrir une large gamme spectrale. En effet, plus le microscope travaille au niveau de la limite de diffraction, plus l'intervalle spectral dans lequel il travaille est étroit du fait de la dispersion de l'indice du verre, c'est-à-dire de sa variation en fonction de la longueur d'onde.

Or, pour l'étude des matériaux semiconducteurs au moyen de sources lasers dont les longueurs d'onde peuvent être dans le créneau de 0,51 µm à 1,06 µm, les longueurs d'onde de photoluminescence peuvent varier entre 0,8 µm et 1,6 µm. La longueur d'onde de photoluminescence dépend en effet du composé étudié, des agents dopants, des impuretés etc. Il est donc nécessaire de disposer d'un large intervalle spectrale pour étudier les matériaux semiconducteurs envisagés, et à l'évidence les dispositifs connus de l'état de la technique ne peuvent résoudre à la fois le problème de la haute résolution et du large intervalle spectral.

De plus, l'étude des matériaux semiconducteurs par photoluminescence à haute résolution ne peut fournir les résultats escomptés que si l'échantillon est disposé sous vide et à des très basses températures (de l'ordre de 10°K).

Un autre dispositif de caractérisation est également connu de l'état de la technique par la demande de brevet européen EP-A-0216077. Ce second document cité décrit un dispositif pour tester sans contact, les noeuds par ailleurs alimentés en tension d'une plaquette de circuit intégré, au moyen d'un faisceau laser pulsé, dans l'ultraviolet, pour produire l'émission de photoélectrons comme une fonction du potentiel à ces noeuds. Ce dispositif comprend des moyens pour convertir une image électronique bidimensionnelle ainsi obtenue, en une image optique enregistrée et analysée par un système vidéo et un ordinateur. La plaquette à tester est montée sur une porte-échantillon. Un faisceau laser pulsé est dirigé vers la plaquette au moyen d'un système optique à lentilles qui produit l'expansion de ce faisceau laser de manière à éclairer la totalité de l'échantillon. Il se produit alors une photoémission pour tous les noeuds sous tension du circuit à tester. La quantité de signal de photoémission à ces noeuds est une fonction de la valeur de la tension qui leur est appliquée, durant l'émission du laser. L'image de photoémission est transformée en une image optique au moyen d'un écran phosphorescent ou fluorescent. Cette image optique est ensuite soumise à des moyens de traitement.

La présente invention a pour but de proposer un dispositif de caractérisation d'échantillons par photoluminescence, qui permet de résoudre tous les problèmes cités plus haut.

Notamment l'invention a pour but de fournir un dispositif qui permet de réaliser des mesures sous le vide requis, à des températures aussi basses que 10°K et sur des grands échantillons, d'au moins "2 pouces" (≃ 5 cm), pouvant aller jusqu'à "4 pouces" (≃ 10 cm).

L'invention a aussi pour but de fournir un dispositif qui permet de réaliser ces mesures avec une meilleure résolution spatiale que celle connue du premier document cité.

L'invention a encore pour but de fournir un dispositif qui permet de réaliser ces mesures avec une plus grande vitesse.

L'invention a en outre pour but de fournir un dispositif qui fonctionne à la limite de la diffraction et sur un large intervalle spectral.

Selon l'invention ces buts sont atteints au moyen d'un dispositif muni des éléments du préambule de la revendication 1 et en outre caractérisé en ce que, la chambre à vide comporte au moins deux fenêtres, unedite première fenêtre latérale permettant l'introduction du faisceau laser incident, et unedite seconde fenêtre fixée à undit support disposé dans la partie supérieure de cette chambre à vide, permettant la sortie du faisceau de photoluminescence,
en ce que les moyens optiques comprennent :
- des premiers moyens optiques, permettant d'envoyer le faisceau laser non focalisé en incidence oblique sur la surface de la plaquette, à travers ladite première fenêtre latérale pour former sur cette plaquette une tache d'éclairement large,
- et des seconds moyens optiques, permettant de former, avec un grandissement supérieur à 1, sur la surface réceptrice du détecteur, l'image de photoluminescence de la tache d'éclairement, et parmi ces seconds moyens, une optique haute résolution, disposée à l'intérieur de la chambre à vide sur le trajet du faisceau de photoluminescence, pour fournir un faisceau image de photoluminescence quasiment parallèle transmis au détecteur à travers ladite seconde fenêtre supérieure, en ce que des moyens mécaniques de déplacement sont appliqués aux moyens optiques, ainsi qu'au détecteur, la plaquette et la chambre à vide restant fixes, et en ce que le détecteur est apte à fournir de l'image de photoluminescence, une image numérisée.

Dans une réalisation préferentielle, ce dispositif est caractérisé en ce que l'optique haute résolution est une optique catadioptrique à miroirs, à large ouverture numérique, travaillant à la limite de diffraction, et disposée sur le trajet du faisceau de photoluminescence, de manière à former à partir d'une zone centrale large de la surface de la tache d'éclairement considérée comme objet, le faisceau image quasiment parallèle, à la longueur d'onde de la photoluminescence, avec un fort grandissement.

Dans une réalisation avantageuse, ce dispositif est caractérisé en ce que lesdits premiers moyens optiques comprennent un système de miroirs plans disposés sur le trajet du faisceau laser incident, pour envoyer ce faisceau laser, à travers ladite première fenêtre latérale, et en ce que lesdits seconds moyens optiques comprennent en outre, pour envoyer le faisceau image de photoluminescence à la surface réceptrice du détecteur, une fois issu de la chambre à vide cryostatique, un système de miroir plan disposé sur le trajet du faisceau.

Dans cette réalisation avantageuse, le dispositif est tel que les moyens mécaniques coopèrent entre eux pour obtenir le déplacement simultané, en grandeur et en direction des premiers et seconds moyens optiques dans deux directions X et Y parallèles au plan de la plaquette échantillon, ainsi que le déplacement du détecteur, et en ce que ces moyens mécaniques coopèrent entre eux pour permettre le déplacement desdits seconds moyens optiques selon une direction Z perpendiculaire au plan de la plaquette, ainsi que le déplacement du détecteur.

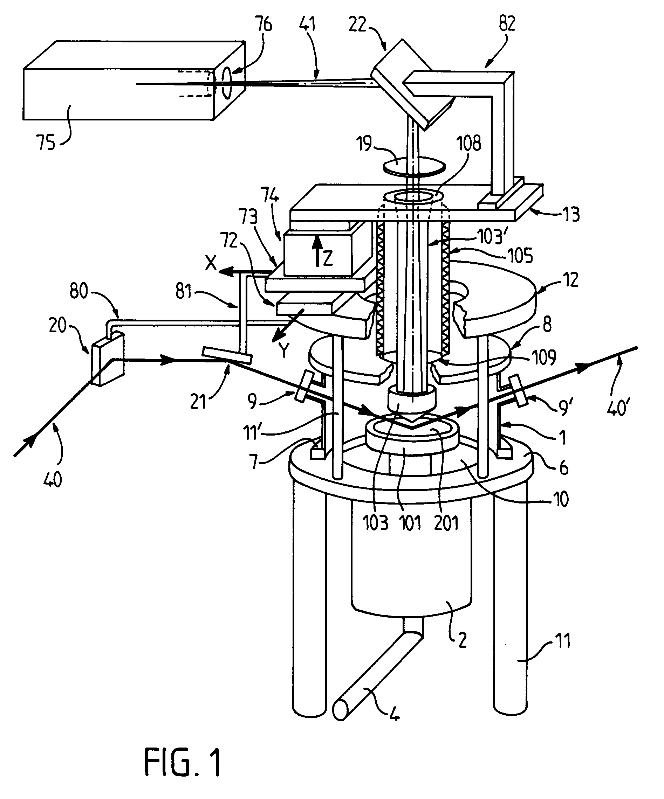

L'invention sera mieux comprise au moyen de la description suivante, illustrée par la figure 1 schématique annexée.

On rappellera d'abord pour mémoire le principe de formation des images de photoluminescence.

Un faisceau-pompe, c'est-à-dire un faisceau laser éclairant la surface d'un matériau semiconducteur est absorbé et génère des paires électrons-trous. Chaque paire diffuse un peu dans le matériau, et perd ainsi un peu d'énergie, mais a une probabilité non nulle de se recombiner pour donner un photon.

Il y a alors émission d'un faisceau de photoluminescence dont la longueur d'onde λ est différente de la longueur d'onde λ₀ du faisceau laser, du fait de la perte d'énergie par diffusion avant recombinaison.

L'énergie perdue dans le matériau n'est pas quelconque et l'énergie finale de recombinaison est caractéristique du matériau, mais aussi des impuretés, de son dopage, de l'alliage qui le constitue, etc...

Lorsque l'on abaisse la température du matériau, le rendement de photoluminescence augmente. Notamment, si l'on considère la valeur de l'intensité du faisceau de photoluminescence en fonction de la longueur d'onde, à température ambiante, on obtient une courbe montrant un maximum, dont la largeur à mi-intensité est grande. Au contraire à basse température, cette courbe montre des pics étroits correspondants par exemple aux impuretés ou à certains éléments constitutifs du matériau.

La caractérisation à basse température par la méthode de photoluminescence permet donc par exemple l'analyse chimique du matériau.

Deux types de caractérisation par photoluminescence peuvent être réalisés. Le premier consiste en une cartographie générale de l'échantillon à étudier, cette cartographie étant alors réalisée à faible résolution. Cette méthode de cartographie est connue par exemple de la publication intitulée "Computer-Controlled Mapping of Photoluminescence Intensities" par Masamichi YOKOGAWA et alii, dans "JPN. J.APPL.PHYS.VOL.23 (1984) N°5, p.663".

Le second type de caractérisation dit à haute résolution consiste à considérer seulement une relativement faible surface de l'échantillon au cours de chaque mesure.

Selon les deux publications citées au titre d'état de la technique dans le préambule, on cherchait même à former une tache d'éclairement par le faisceau laser très petite, de l'ordre de 2 µm, la dimension de cette tache d'éclairement fixant alors la limite de résolution.

Selon l'invention au contraire, on va former une grande tache d'éclairement par le faisceau laser. Cette grande tache d'éclairement est obtenue en amenant le faisceau laser non focalisé et en incidence oblique sur l'échantillon. Ainsi formée, la tache d'éclairement est de l'ordre de 2mm x 5 mm. Au voisinage du centre de cette tache d'éclairement, on choisit une zone de dimensions 300 µm x 300 µm.

Cette zone de 300 µm x 300 µm sert d'objet pour une optique haute résolution, qui projette son image sur la surface sensible d'une caméra capable de fournir une image numérisée.

Cette optique haute résolution est une optique catadioptrique à miroirs, à grande ouverture numérique, qui travaille à la limite de la diffraction.

De plus, cette optique est disposée de telle sorte qu'il n'y as pas de fenêtre de verre entre l'optique et l'échantillon.

En effet, si une optique travaillant à la limite de la diffraction inclut des lentilles en verre, ou bien est séparée de l'échantillon par une fenêtre en verre, alors l'intervalle spectral dans lequel l'optique peut travailler devient très étroit, du fait de la dispersion de l'indice du verre.

Selon l'invention, l'échantillon est disposé dans une chambre à vide cryostatique, pour permettre le refroidissement de l'échantillon, pour les avantages de caractérisation des éléments du matériau, cités précédemment, et, dans le but d'éviter que le faisceau traverse une fenêtre en verre, comme il était connu de l'état de la technique, d'une part l'optique est du type à miroirs, et d'autre part l'optique est disposée à l'intérieur même de la chambre à vide cryostatique.

Ainsi, l'on obtient de pouvoir utiliser un rayonnement laser dont la longueur d'onde peut être 0,51 µm (Ar) ou 1,06 µm (YAG), selon le système physique à étudier, ce qui conduit à obtenir pour les semiconducteurs un rayonnement de photoluminescence dont la longueur d'onde peut aller de 0,8 µm à 1,6 µm selon l'alliage. Selon l'invention, on peut donc travailler dans une large gamme spectrale.

Le fait de placer l'optique à l'intérieur de la chambre à vide cryostatique fait que, le faisceau sortant de l'optique et traversant une fenêtre de la chambre à vide cryostatique est à cet endroit pratiquement parallèle. Il n'est donc pas perturbé par la traversée de la fenêtre en verre. Comme on l'a vu, il en était tout autrement dans les dispositifs connus, où la fenêtre était interposée sur un faisceau de photoluminescence fortement divergent, de même que sur le faisceau laser d'éclairement qui était lui aussi divergent à cet endroit.

Selon l'invention, une région de 300 µm x 300 µm de l'échantillon est donc projetée à l'aide de cette optique sur la surface sensible de diamètre environ 25 mm (1 pouce) d'une caméra, par exemple à C.C.D, ou de tout autre détecteur capable de traiter une information en parallèle. Cette méthode permet d'effectuer la caractérisation d'une façon beaucoup plus rapide que selon l'art antérieur où il fallait balayer une surface à l'aide d'un point de 2 µm.

Ici, la qualité de l'image projetée par l'optique a une résolution de 1 µm. Le grandissement obtenu au niveau de la surface sensible de la caméra est environ 60. La caméra donne une image numérisée qui peut être au mieux de 1024 points x 1024 points.

Donc, sur une ligne de 300 µm, la photoluminescence est collectée tous les 0,3 µm.

Comme on l'a dit, l'optique à miroirs ne distingue que des détails de 1 µm. En collectant la photoluminescence tous les 0,3 µm, on fait donc du "suréchantillonnage". On collecte ainsi plus de points qu'il n'est nécessaire du point de vue du traitement de signal classique. Cette méthode a l'avantage de permettre de mieux s'affranchir du "bruit".

D'autre part, du fait de la diffusion des porteurs, c'est-à-dire des paires électrons-trous, photogénérés, diffusion qui est supérieure au µm, une perturbation locale (par exemple une impureté, un élément dopant etc) du semiconducteur va donner un signal de photoluminescence qui s'étendra aussi sur plus d'1 µm. Ce n'est donc pas la résolution de l'optique qui limitera la résolution de l'image de photoluminescence.

De plus, une telle haute résolution de l'optique sera utilisée pour visualiser les motifs de technologie qui se trouvent en surface de l'échantillon semiconducteur et dont certains sont submicroniques. Une aussi haute résolution que 1 µm n'est donc pas superflue.

On décrit ci-après à l'aide des figures une mise en oeuvre préférentielle de l'invention.

Tel que représenté sur la figure 1, le dispositif selon l'invention comprend d'abord une chambre à vide 1, munie d'une embase inférieure 7, et d'une embase supérieure 8. La chambre à vide 1 peut être favorablement cylindrique et reposer sur le support plan 6 par son embase inférieure 7 munie d'un joint d'étanchéité au vide.

La chambre à vide comporte 2 fenêtres latérales 9 et 9′, la première 9 pour permettre l'introduction du faisceau laser incident 40, et la seconde 9′ pour permettre la sortie du faisceau laser 40′ réfléchi par l'échantillon 201.

La chambre à vide comporte ensuite une ouverture 10 pratiquée dans le support 6. Par cette ouverture 10, peut être introduit le porte-échantillon 101, muni de l'échantillon 201, relié au cryostat 2. Le cryostat 2 comporte un serpentin interne qui peut être alimenté en hélium liquide par l'entrée 4. Une pompe non représentée permet la circulation de l'hélium liquide dans le serpentin. L'hélium liquide ressort du cryostat par une seconde embouchure non montrée sur la figure. Le porte-échantillon est favorablement en cuivre. Il est en outre muni d'un thermocouple, non représenté, pour permettre la mesure de sa température. L'échantillon de matériau semiconducteur, ou même la plaquette de circuit intégré, disposée en 201 à la surface du porte-échantillon peut donc être refroidi par ce système environ jusqu'à 10°K.

Pour la mise en oeuvre de l'invention, on peut utiliser un cryostat du commerce par exemple le cryostat "Helium type Bidon", de la société SMC TBT (France). Pour constituer les fenêtres 9 et 9′, on peut utiliser des "hublots à souder, de diamètre 40 mm, "référence HV 40S" de la Société SVT (France).

Les hublots 9 et 9′ sont disposés latéralement sur la chambre à vide 1 de telle manière que l'angle d'incidence du faisceau laser 40, soit de l'ordre de 70°.

Le support 6 de la chambre à vide et du cryostat peut être fixé sur un banc d'optique ou marbre au moyen des fixations 11. Le cryostat lui-même est monté de manière étanche sur le support 6.

Les moyens pour faire le vide dans la chambre à vide 1 n'apparaissent pas sur la figure 1a pour des raisons de lisibilité du dessin.

La chambre à vide 1 comporte encore une ouverture 109 pratiquée dans l'embase supérieure 8. Cette ouverture 109, prévue suffisamment grande pour permettre les déplacements X,Y dont on parle plus loin, permet le passage d'un tube creux 103′, servant de porte-objectif, à l'extrémité inférieure duquel est fixée l'optique catadioptrique 103 maintenue ainsi au-dessus de l'échantillon 201. La partie supérieure du porte-objectif 103′ est rendue solidaire du support 13.

Un soufflet métallique 105 relie de façon étanche le support 13 à l'embase 8. L'étanchéité au vide, vis-à-vis de la chambre à vide, du support 13 est obtenue par une fenêtre 108, qui permet le passage du faisceau transporté par l'optique 103.

Un support 12 est rendu solidaire du support 6 par des fixations 11′. Sur ce support 12 est fixé un micromanipulateur à trois degrés de liberté X, Y et Z, dont la dernière platine 74 douée du mouvement Z est rendue solidaire du support 13. Dans ces conditions le support 13 peut être soumis aux mouvements parallèles à X par la platine 73, aux mouvements Y par la platine 72 et aux mouvements Z par la dernière platine 74. Ces mouvements sont transmis par le support 13 et le porte-objectif 103′, à l'optique 103 qui peut donc être déplacée dans les directions X et Y parallèles au plan de l'échantillon 201, et dans la direction Z pour la mise au point. Le soufflet 105 dont la partie supérieure se déplace en même temps, dans les mêmes directions et des mêmes distances permet de conserver le vide dans la chambre à vide 1 lorsque l'optique est déplacée devant l'échantillon. On peut se procurer à cet effet un soufflet métallique étanche de 60 ondes chez la Société CALORSTAT (France).

Les translations X, Y, Z peuvent être obtenues au moyen de dispositifs du commerce. Notamment, on peut réaliser les translations X et Y au moyen de deux platines de référence "UT 100 PP" de la société MICROCONTROLE (France) et on peut réaliser le mouvement de translation verticale Z au moyen d'une platine "MV 80" de la société MICROCONTROLE (France).

Comme on le voit, selon l'invention, c'est l'optique 103, laquelle transporte le faisceau de photoluminescence 41, qui se déplace vis-à-vis de l'échantillon, ce dernier et la chambre à vide étant fixes, au contraire de ce qui se passait dans les dispositifs connus de l'état de la technique.

Par ces déplacements, l'optique est apte à observer l'échantillon en tout endroit de sa surface, dans la mesure où chaque plage observée est excitée par le faisceau laser. A cet effet, le faisceau laser 40 est amené sur l'échantillon 201 après deux réflexions sur les miroirs 20 et 21. Ces miroirs sont disposés de telle sorte, qu'en reliant le premier 20, par la fixation 80, au mouvement Y de la platine 72, et en reliant l'autre 21 par la fixation 81 au mouvement X de la platine 73, la tache d'éclairement provoquée par le faisceau laser à la surface de l'échantillon se déplace exactement dans les mêmes directions et proportions que l'objectif de l'optique catadioptrique 103.

On voit que dans ces conditions le faisceau laser 40 n'est pas focalisé. Il forme une tache large (2 x 5 mm) sur l'échantillon.

L'optique catadioptrique 103 est disposée de manière à observer une plage de 300 µm x 300 µm dans cette tache d'éclairement. Comme optique catadioptrique à miroirs, à grande ouverture numérique on peut utiliser une optique du commerce, par exemple "Planopochromat 40/0,5, focale 6,3 mm catadioptrique" de la société ZEISS. Elle fournit une résolution de 1 µm.

Le faisceau de photoluminescence 41 sortant de l'optique 103, traversant la fenêtre 108 alors qu'il est pratiquement parallèle n'est pas perturbé par le verre de cette fenêtre. Elle peut donc être de diamètre suffisamment grand, et surtout suffisamment épaisse pour tenir au vide.

Sortant de la chambre à vide par la fenêtre 108, le faisceau de photoluminescence traverse encore un filtre 19, chargé de couper la lumière à la longueur d'onde du faisceau laser, pour laisser passer seulement la lumière à la longueur d'onde de photoluminescence.

Puis le faisceau de photoluminescence 41 est dirigé au moyen du miroir 22, vers la surface sensible 76 de la caméra 75, où il va former une image d'environ 18 mm x 18 mm. Ce miroir 22 est solidaire du support 13 par la fixation 82 et est disposé de telle sorte qu'il suive les mouvements de ce support 13. Afin que l'image de la plage observée par l'optique sur l'échantillon se forme de façon fixe sur la surface 76, la caméra 75 est également solidaire des mouvements X, Y, Z par un dispositif non représenté sur la figure 1.

La caméra numérique apte à traiter le faisceau de photoluminescence pour en fournir une image numérisée comme il a été dit précédemment peut être une caméra du commerce telle que "C 1000, type 02" de la société HAMAMATSU (Japon).

Les données sont transmises par l'intermédiaire d'une unité de contrôle d'une part à un ordinateur (par exemple PDP 11.73 de la Société DIGITAL EQUIPMENT CORPORATION) en mode accès mémoire direct (DMA) et d'autre part à un écran VIDEO. La durée typique requise pour l'acquisition d'une image de 1024 x 1024 points est une trentaine de secondes.

Enfin, les mouvements X, Y, Z peuvent être motorisés afin d'automatiser l'enregistrement. Les sources lasers peuvent être par exemple :
- un laser argon de chez SPECTRA PHYSICS "Modèle 165",
- un laser YAG de chez MICROCONTROLE, Modèle "YAG 904" (Société Française).

Un laser HeNe peut être utilisé pour réaliser l'alignement préliminaire de l'ensemble du système optique, afin d'atteindre le but de déplacer bien simultanément la tache d'éclairement dont la position dépend de l'orientation et de la position des miroirs 20 et 21, et l'optique 103, le miroir 22 et la caméra 75, dont dépend la fixité de l'image sur la surface 76 de caméra 75.

Le choix des sources laser dépend des échantillons soumis à la caractérisation.

## Revendications

1. Dispositif de caractérisation de plaquettes (201) de matériaux semiconducteurs par photoluminescence à haute résolution spatiale et à basse température, ce dispositif comprenant au moins :
a) une chambre à vide (1) cryostatique, munie d'un porte-échantillon (101) refroidi pour recevoir les plaquettes, et munie d'au moins une fenêtre pour la transmission des faisceaux lumineux impliqués dans le procédé de photoluminescence ;
b) des moyens optiques pour former une tache d'éclairement sur la plaquette (201) à partir d'un faisceau laser et pour transmettre le faisceau de photoluminescence réémis à un détecteur, caractérisé en ce que, la chambre à vide comporte au moins deux fenêtres, unedite première fenêtre latérale (9) permettant l'introduction du faisceau laser incident (40), et unedite seconde fenêtre (108) fixée à undit support (13) disposé dans la partie supérieure de cette chambre à vide, permettant la sortie du faisceau de photoluminescence,
en ce que les moyens optiques comprennent :
- des premiers moyens optiques (20,21), permettant d'envoyer le faisceau laser (40) non focalisé en incidence oblique sur la surface de la plaquette (201), à travers ladite première fenêtre latérale (9) pour former sur cette plaquette une tache d'éclairement large,
- et des seconds moyens optiques (103,19,22), permettant de former, avec un grandissement supérieur à 1, sur la surface réceptrice (76) du détecteur (75), l'image de photoluminescence de la tache d'éclairement, et parmi ces seconds moyens, une optique haute résolution (103), disposée à l'intérieur de la chambre à vide (1) sur le trajet du faisceau de photoluminescence, pour fournir un faisceau image de photoluminescence quasiment parallèle transmis au détecteur à travers ladite seconde fenêtre supérieure (108), en ce que des moyens mécaniques de déplacement (72,73,74) sont appliqués aux moyens optiques (20,21,103,22), ainsi qu'au détecteur (75), la plaquette (201) et la chambre à vide (1) restant fixes, et en ce que le détecteur (75) est apte à fournir de l'image de photoluminescence, une image numérisée.

2. Dispositif selon la revendication 1, caractérisé en ce que l'optique haute résolution est une optique catadioptrique (103) à miroirs, à large ouverture numérique, travaillant à la limite de diffraction, et disposée sur le trajet du faisceau de photoluminescence, de manière à former à partir d'une zone centrale large de la surface de la tache d'éclairement considérée comme objet, le faisceau image quasiment parallèle, à la longueur d'onde de la photoluminescence, avec un fort grandissement.

3. Dispositif selon la revendication 2, caractérisé en ce que lesdits premiers moyens optiques comprennent un système de miroirs plans (20,21) disposés sur le trajet du faisceau laser incident (40), pour envoyer ce faisceau laser, à travers ladite première fenêtre latérale (9), et en ce que lesdits seconds moyens optiques comprennent en outre, pour envoyer le faisceau image de photoluminescence (41) à la surface réceptrice (76) du détecteur (75), une fois issu de la chambre à vide cryostatique, un système de miroir plan (22) disposé sur le trajet du faisceau.

4. Dispositif selon la revendication 3, caractérisé en ce que les moyens mécaniques (72,73,74) coopèrent entre eux pour obtenir le déplacement simultané, en grandeur et en direction des premiers (20,21) et seconds moyens (103,22) optiques dans deux directions X et Y parallèles au plan de la plaquette échantillon (201), ainsi que le déplacement du détecteur (75), et en ce que ces moyens mécaniques coopèrent entre eux pour permettre le déplacement desdits seconds moyens optiques (103,22) selon une direction Z perpendiculaire au plan de la plaquette (201), ainsi que le déplacement du détecteur (75).

5. Dispositif selon la revendication 4, caractérisé en ce que les moyens mécaniques comprennent une platine à trois degrés de liberté (72,73,74), fixée au support (13) de ladite seconde fenêtre (108), en ce que les mouvements de déplacement sont transmis à l'optique catadioptrique (103) dans la chambre à vide par l'intermédiaire d'un porte-objectif (103') solidaire du support (13) de la seconde fenêtre (108), et en ce que, pour maintenir le vide durant les déplacements, un soufflet (105) étanche au vide relie ledit support (13) de seconde fenêtre au corps de la chambre à vide (1) cryostatique.

6. Dispositif selon la revendication 5, caractérisé en ce que, pour obtenir le déplacement simultané des premiers (20,21) et seconds (103,22) moyens optiques, lesdits premiers moyens optiques sont constitués de deux miroirs plans (20,21) disposés sur le trajet du faisceau laser incident, chacun d'eux étant solidaire d'une partie mécanique de la platine à trois degrés de liberté, pour être lié respectivement à un mouvement parallèle à l'une des directions X ou Y, de manière à obtenir le déplacement de la tache d'éclairement, à la surface de la plaquette, d'une grandeur donnée selon ces directions X ou Y, en ce que, dans lesdits seconds moyens optiques, le système de renvoi du faisceau de photoluminescence est constitué d'un miroir plan (22) et en ce que ces seconds moyens optiques (22,103,103') et le détecteur (75) sont liés audit support (13) de seconde fenêtre qui leur transmet les mouvements X et Y pour suivre les déplacements de la tache d'éclairement et le mouvement Z pour permettre la mise au point de l'optique catadioptrique (103).

7. Dispositif selon l'une des revendications précédentes, caractérisé en ce que lesdits seconds moyens optiques comprennent aussi, pour éliminer les radiations de longueurs d'onde autres que la longueur d'onde de photoluminescence, un filtre (19) disposé sur le trajet du faisceau (41) entre la chambre à vide (1) cryostatique et le détecteur (75).

8. Dispositif selon l'une des revendications précédentes, caractérisé en ce que le porte-échantillon (101) est relié à un cryostat (2) permettant d'obtenir le refroidissement de la plaquette échantillon (201), ce cryostat étant solidaire de la chambre à vide (1) pour maintenir l'étanchéité au vide de ladite chambre.

9. Dispositif selon la revendication 8, caractérisé en ce que le cryostat (2) fonctionne à l'hélium liquide, pour permettre d'obtenir des températures de la plaquette échantillon de l'ordre de 10°K.

10. Dispositif selon la revendication 9, caractérisé en ce que, pour obtenir le refroidissement du porte-échantillon (101) et de l'échantillon (201) par l'hélium liquide, le cryostat comprend un serpentin dans lequel la circulation de l'hélium liquide se fait à l'aide d'une pompe.

11. Dispositif selon l'une des revendications précédentes, caractérisé en ce que pour contrôler la température de l'échantillon, le porte-échantillon (101) est muni d'un thermocouple.

12. Dispositif selon l'une des revendications précédentes, caractérisé en ce que le porte-échantillon (101) est en cuivre.

13. Dispositif selon l'une des revendications précédentes, caractérisé en ce que le détecteur (75) est une caméra numérique à C.C.D., dont les données sont reportées sur un ordinateur et sur un écran vidéo.

14. Dispositif selon l'une des revendications précédentes, caractérisé en ce que les moyens mécaniques sont motorisés.

15. Dispositif selon l'une des revendications précédentes, caractérisé en ce que le faisceau laser incident (40) est issu d'une source choisie parmi un laser à argon ou un laser à YAG permettant d'obtenir des rayonnements incidents de longueurs d'onde respectives 0,51 µm ou 1,06 µm.

16. Dispositif selon l'une des revendications précédentes, caractérisé en ce que la source utilisée pour réaliser l'alignement optique est un laser Helium-Néon.

17. Dispositif selon l'une des revendications précédentes, caractérisé en ce que la chambre à vide comporte en outre, pour la sortie du faisceau laser réfléchi (40') par la plaquette (201), une autre fenêtre latérale (9) symétrique de ladite première fenêtre latérale.

## Claims

1. A device for characterizing wafers of semiconductor materials by photoluminescence with high spatial resolution and at low temperature, this device comprising at least:
a) a cryostatic vacuum chamber provided with a cooled sample carrier for receiving the wafers and provided with at least one window for the transmission of the light beams used in the photoluminescence process;
b) optical means for forming a luminous spot on the wafer from a laser beam and for transmitting the re-emitted photoluminescence beam to a detector, characterized in that the vacuum chamber comprises at least two windows, a first, lateral window (9) for the introduction at the incident laser beam (40), and a second window (108) fixed to a support (13) arranged in the upper portion of said vacuum chamber for the exit of the photoluminescence beam, in that the optical means comprise:
- first optical means (20, 21) which render it possible to send the laser beam (40) non-focused and obliquely incident onto the surface of the wafer (201) through the first, lateral window (9) so as to form a large illumination spot on this wafer,
- and second optical means (103, 19, 22) which render it possible to form the photoluminescence image of the illumination spot on the receiving surface (76) of the detector (75) with a magnification greater than 1, which second means comprise a high-resolution optical system (103) arranged inside the vacuum chamber (1) in the path of the photoluminescence beam for forming a quasi-parallel photoluminescence image beam which is transmitted to the detector through said second, upper window (108), in that mechanical displacement means (72, 73, 74) are applied to the optical means (20, 21, 103, 22) and to the detector (75), the wafer (201) and the vacuum chamber (1) remaining fixed, and in that the detector (75) is capable of providing a digitized image obtained from the photoluminescence image.

2. A device claimed in Claim 1, characterized in that the high-resolution optical system is a catadioptric mirror system (103) with a wide numeral aperture, operating at the diffraction limit and arranged in the path of the photoluminescence beam so as to form the quasi-parallel image beam at the photoluminescence wavelength with high magnification from a large cental surface zone of the illumination zone which is regarded as the object.

3. A device as claimed in Claim 2, characterized in that said first optical means comprise a system of plane mirrors (20, 21) arranged in the path of the incident laser beam (40) so as to send this laser beam through said first, lateral window (9), and in that said second optical means in addition comprise a system of the plane mirror (22) arranged in the path of the photoluminescence image beam so as to send this beam to the receiving surface (76) of the detector (75) after it has left the cryostatic vacuum chamber.

4. A device as claimed in Claim 3, characterized in that the mechanical means (72, 73, 74) cooperate with one another for obtaining the simultaneous displacement, both as regards distance and as regards direction, of the first (20, 21) and second optical means (103, 22) in two directions X and Y parallel to the plane of the sample wafer (201), as well as the displacement of the detector (75), and in that said mechanical means cooperate with one another for obtaining the displacement of said second optical means (103, 22) in a Z-direction perpendicular to the plane of the wafer (201) as well as the displacement of the detector (75).

5. A device as claimed in Claim 4, characterized in that the mechanical means comprise a platform having three degrees of freedom (72, 73, 74) fixed to the support (13) of the said second window (108), in that the movements of displacement are transmitted to the catadioptric optical system (103) in the vacuum chamber by means of an objective carrier (103') integral with the support (13) of the second window (108), and in that, in order to maintain a vacuum during displacements, vacuum-tight bellows (105) connect the said support (13) of the second window to the body of the cryostatic vacuum chamber (1).

6. A device as claimed in Claim 5, characterized in that, in order to obtain the simultaneous displacement of the first (20, 21) and the second (103, 22) optical means, the said first optical means are constituted by two flat mirrors (20, 21) arranged in the path of the incident laser beam, each of these mirrors being integral with a mechanical part of the platform having three degrees of freedom so as to be connected to a movement parallel to one of the respective directions X or Y in order to obtain the displacement of the luminous spot at the surface of the wafer over a given distance in these directions X or Y, in that in the said second optical means the system for returning the photoluminescence beam is constituted by a flat mirror (22), and in that said second optical means (22, 103, 103') and the detector (75) are connected to the said support (13) of the second window which transmits the movements X and Y thereto so as to follow the displacements of the luminous spot and the Z-movement so as to permit the positioning of the catadioptric optical system (103).

7. A device as claimed in any one of the preceding Claims, characterized in that the said optical means further comprise a filter (10) arranged in the path of the beam (41) between the cryostatic vacuum chamber (1) and the detector (75) for elimination of the radiations having wavelengths different from the photoluminescence.

8. A device as claimed in any one of the preceding Claims, characterized in that the sample carrier (101) is connected to a cryostat (2) which permits of obtaining the cooling of the sample wafer (201), this cryostat being integral with the vacuum chamber (1) in order to achieve the vacuumtightness of the said chamber.

9. A device as claimed in Claim 8, characterized in that the cryostat (2) operates with liquid helium so as to permit of obtaining temperatures of the sample wafer of the order of 10°K.

10. A device as claimed in Claim 9, characterized in that, in order to obtain the cooling of the sample carrier (101) and of the sample (201) by liquid helium, the cryostat comprises a serpentine in which the circulation of liquid helium is obtained by means of a pump.

11. A device as claimed in any one of the preceding Claims, characterized in that, in order to control the temperature of the sample, the sample carrier (101) is provided with a thermocouple.

12. A device as claimed in any one of the preceding Claims, characterized in that the sample carrier (101) consists of copper.

13. A device as claimed in any one of the preceding Claims, characterized in that the detector (75) is a digital camera of the C.C.D. type whose data are transmitted to a computer and to a video screen.

14. A device as claimed in any one of the preceding Claims, characterized in that the mechanical means are motorized.

15. A device as claimed in any one of the preceding Claims, characterized in that the incident laser beam (40) originates from a source chosen a between an argon laser and a YAG laser permitting of obtaining incident radiations having wavelengths of 0.51 µm and 1.06 µm, respectively.

16. A device as claimed in any one of the preceding Claims, characterized in that the source used to obtain the optical alignment is a helium-neon laser.

17. A device as claimed in any one of the preceding Claims, characterized in that the vacuum chamber in addition comprises another lateral window (9) symmetrical with said first lateral window for the exit of the laser beam (40') reflected by the wafer (201).

## Patentansprüche

1. Vorrichtung zur Charakterisierung von Scheiben (201) aus Halbleitermaterial durch räumlich hochauflösende Photolumineszenz bei niedriger Temperatur, wobei diese Vorrichtung mindestens enthält:
a) eine kryostatische Vakuumkammer (1), mit einem gekühlten Probenhalter (101) zum Aufnehmen der Scheiben und mit mindestens einem Fenster zum Hindurchlassen des für das Photolumineszenz-Verfahren verwendeten Lichtbündels;
b) optische Mittel, um, ausgehend von einem Laserstrahlenbündel, einen Lichtfleck auf der Scheibe (201) zu erzeugen und um das zurückgestrahlte Photolumineszenzstrahlenbündel zu einem Detektor zu übertragen, dadurch gekennzeichnet, daß die Vakuumkammer mindestens zwei Fenster enthält, nämlich ein erstes seitliches Fenster (9), durch das das Laserstrahlenbündel (40) eintritt, sowie ein zweites Fenster (108), das in einer Halterung (13) im oberen Teil der Vakuumkammer befestigt ist, und durch das das Photolumineszenzstrahlenbündel diese wieder verläßt,
daß die optischen Mittel die folgenden Teile enthalten:
- erste optische Mittel (20, 21), durch die das nicht fokussierte Laserstrahlenbündel (40) durch das erste seitliche Fenster (9) schräg auf die Oberfläche der Scheibe (201) auftrifft, um dort einen breiten Lichtfleck zu bilden,
- sowie zweite optische Mittel (103, 19, 22) durch die mit einer Vergrößerung größer als 1 auf der lichtempfindlichen Fläche (76) eines Detektors (75) das Photolumineszenz-Bild des Lichtflecks erzeugt wird, wobei diese zweiten optischen Mittel eine innerhalb der Vakuumkammer (1) im Strahlengang des Photolumineszenzstrahlenbündels angeordnete hochauflösende Optik (103) enthalten, die durch das zweite obere Fenster (108) hindurch ein quasi-paralleles Strahlenbündel des Photolumineszenz-Bildes auf den Detektor projiziert, daß mechanische Verschiebemittel (72, 73, 74) mit den optischen Mitteln (20, 21, 103, 22) und dem Lichtdetektor (75) verbunden sind, während die Scheibe (201) und die Vakuumkammer (1) ortsfest bleiben, und daß der Detektor (75) aus dem Photolumineszenz-Bild ein digitalisiertes Bild liefern kann.

2. Vorrichtung nach Anspruch 1, dadurch gekennzeichnet, daß die hochauflösende Optik eine katadioptrische Spiegeloptik (103) mit großer numerischer Apertur ist, die im Beugungsgrenzbereich arbeitet und so im Photolumineszenz-Strahlengang angeordnet ist, daß sie aus einem breiten zentralen Bereich des Lichtflecks, der als Objekt angesehen wird, mit starker Vergrößerung und bei der Wellenlänge der Photolumineszenz das quasi-parallele Bild-Strahlenbündel erzeugt.

3. Vorrichtung nach Anspruch 2, dadurch gekennzeichnet, daß die ersten optischen Mittel ein im Strahlengang des einfallenden Laserstrahlenbündels (40) angeordnetes System aus Planspiegeln (20, 21) enthalten, um dieses Laserstrahlenbündel durch das erste seitliche Fenster (9) hindurch zu leiten, und daß die zweiten optischen Mittel darüberhinaus ein im Photolumineszenz-Strahlengang angeordnetes Planspiegelsystem (22) enthalten, um das aus der kryostatischen Vakuumkammer ausgetretene Photolumineszenzstrahlenbündel (41) auf die lichtempfindliche Fläche (76) des Detektors (75) zu lenken.

4. Vorrichtung nach Anspruch 3, dadurch gekennzeichnet, daß die mechanischen Mittel (72, 73, 74) zusammenwirken, um eine in Betrag und Richtung gleichzeitige Verschiebung der ersten optischen Mittel (20, 21) und der zweiten optischen Mittel (103, 22) in zwei zur Ebene der Probenscheibe (201) parallelen Richtungen X und Y sowie eine Verschiebung des Detektors (75) zu erreichen, und daß die mechanischen Mittel zusammenwirken, um eine Verschiebung der zweiten optischen Mittel (103, 22), in einer zur Ebene der Scheibe (201) senkrechten Richtung Z sowie eine Verschiebung des Detektors (75) zu ermöglichen.

5. Vorrichtung nach Anspruch 4, dadurch gekennzeichnet, daß die mechanischen Mittel einen Koordinatenschlitten mit drei Freiheitsgraden (72, 73, 74) enthalten, der an der Halterung (13) des zweiten Fensters (108) befestigt ist, daß die Verschiebebewegungen mittels des mit der Halterung (13) des zweiten Fensters (108) fest verbundenen Objektivträgers (103') an die katadioptrische Optik (103) in der Vakuumkammer übertragen werden, und daß zum Aufrechterhalten des Vakuums während der Bewegungen ein vakuumdichter Faltenbalg (105) die Halterung (13) des zweiten Fensters mit dem Gehäuse der kryostatischen Vakuumkammer (1) verbindet.

6. Vorrichtung nach Anspruch 5, dadurch gekennzeichnet, daß, um die gleichzeitige Verschiebung der ersten optischen Mittel (20, 21) und der zweiten optischen Mittel (103, 22) zu erreichen, die ersten optischen Mittel aus zwei in den Strahlengang des einfallenden Laserstrahlenbündels angeordneten Planspiegeln (20, 21) bestehen, die jeweils mit einem mechanischen Teil des Koordinatenschlittens mit drei Freiheitsgraden fest verbunden sind, so daß jeder von ihnen einer Bewegung parallel zur X- oder Y-Richtung unterliegt, um eine Verschiebung des Lichtflecks auf der Scheibenoberfläche um einen bestimmten Betrag in X- bzw. Y-Richtung zu erreichen, daß innerhalb dieser zweiten optischen Mittel die Umlenkvorrichtung für das Photolumineszenzstrahlenbündel aus einem Planspiegel (22) besteht, und daß diese zweiten optischen Mittel (22, 103, 103') und der Detektor (75) mit der Halterung (13) des zweiten Fensters verbunden sind, die die Bewegungen in X- und Y-Richtung auf sie überträgt, um den Verschiebungen des Laser-Lichtflecks zu folgen, sowie die Bewegung in Z-Richtung überträgt, um die katadioptrische Optik (103) scharfzustellen.

7. Vorrichtung nach einem der vorhergehenden Ansprüche, dadurch gekennzeichnet, daß die zweiten optischen Mittel außerdem ein in den Strahlengang des Strahlenbündels (41) zwischen der kryostatischen Vakuumkammer (1) und dem Detektor (75) eingefügtes optisches Filter (19) enthalten, um Strahlung mit anderen Wellenlängen als die Wellenlänge der Photolumineszenz auszufiltern.

8. Vorrichtung nach einem der vorhergehenden Ansprüche, dadurch gekennzeichnet, daß der Probenhalter (101) an einen Kryostat (2) angeschlossen ist, der die Probenscheibe (201) kühlt, wobei dieser Kryostat fest mit der Vakuumkammer (1) verbunden ist, um die Dichtheit dieser Kammer aufrechtzuerhalten.

9. Vorrichtung nach Anspruch 8, dadurch gekennzeichnet, daß der Kryostat (2) mit flüssigem Helium arbeitet, so daß Probenscheibentemperaturen in der Größenordnung von 10°K erreicht werden können.

10. Vorrichtung nach Anspruch 9, dadurch gekennzeichnet, daß, um die Kühlung des Probenhalters (101) und der Probe (201) mittels des flüssigen Heliums zu erreichen, der Kryostat mit einer Kühlschlange ausgerüstet ist, durch die mittels einer Pumpe flüssiges Helium fließt.

11. Vorrichtung nach einem der vorhergehenden Ansprüche, dadurch gekennzeichnet, daß der Probenhalter (101) zur Überwachung der Temperatur mit einem Thermoelement ausgerüstet ist.

12. Vorrichtung nach einem der vorhergehenden Ansprüche, dadurch gekennzeichnet, daß der Probenhalter (101) aus Kupfer ist.

13. Vorrichtung nach einem der vorhergehenden Ansprüche, dadurch gekennzeichnet, daß der Detektor (75) eine digitale CCD-Kamera ist, deren Daten an einen Computer und einen Video-Bildschirm übermittelt werden.

14. Vorrichtung nach einem der vorhergehenden Ansprüche, dadurch gekennzeichnet, daß die mechanischen Mittel mit Antrieben ausgerüstet sind.

15. Vorrichtung nach einem der vorhergehenden Ansprüche, dadurch gekennzeichnet, daß das einfallende Laserstrahlenbündel (40) je nach Wahl aus einem Argon-Laser oder aus einem YAG-Laser stammt, wobei Einfallsstrahlung mit einer Wellenlänge von 0,51 µm bzw. 1,06 µm erzeugt werden kann.

16. Vorrichtung nach einem der vorhergehenden Ansprüche, dadurch gekennzeichnet, daß die für die optische Justierung verwendete Quelle ein Helium-Neon-Laser ist.

17. Vorrichtung nach einem der vorhergehenden Ansprüche, dadurch gekennzeichnet, daß die Vakuumkammer außerdem für den Austritt des von der Scheibe (201) reflektierten Laserstrahlenbündels (40') ein weiteres, symmetrisch zum ersten seitlichen Fenster (9) angeordnetes, seitliches Fenster (9') umfaßt.
